## Europäisches Patentamt

## European Patent Office

## Office européen des brevets

(19)

(11) Veröffentlichungsnummer: **0 099 897**
**B1**

(12) **EUROPÄISCHE PATENTSCHRIFT**

(45) Veröffentlichungstag der Patentschrift:
24.09.86

(51) Int. Cl.⁴: **H 01 L 27/08**, H 01 L 29/06

(21) Anmeldenummer: **83900183.1**

(22) Anmeldetag: **30.12.82**

(86) Internationale Anmeldenummer:
**PCT/DE 82/00234**

(87) Internationale Veröffentlichungsnummer:
**WO 83/02528 (21.07.83 Gazette 83/17)**

(54) **DARLINGTON-TRANSISTORSCHALTUNG.**

(30) Priorität: **20.01.82 DE 8201186 U**
**23.07.82 DE 3227536**

(43) Veröffentlichungstag der Anmeldung:
**08.02.84 Patentblatt 84/6**

(45) Bekanntmachung des Hinweises auf die Patenterteilung:
**24.09.86 Patentblatt 86/39**

(84) Benannte Vertragsstaaten:
**DE FR GB NL**

(56) Entgegenhaltungen:
**DE-A-1 614 991**
**DE-A-2 256 688**
**US-A-3 845 495**
**US-A-3 858 235**
**US-A-4 167 748**

**IEEE Transactions on Consumer Electronics Band
CE026, No. 3, August 1980 (New York, USA)
Imaizumi et al "Novel IC structure for 150v highvoltage consumer IC", pages 367-374, see page 371,
column 1, figure 7**

(73) Patentinhaber: **ROBERT BOSCH GMBH, Postfach
50, D-7000 Stuttgart 1 (DE)**

(72) Erfinder: **FLOHRS, Peter, Schickardtstrasse 69,
D-7410 Reutlingen 11 (DE)**

## Description

### Stand der Technik

Die Erfindung betrifft eine Darlington-Transistorschaltung nach der Gattung des Hauptanspruchs.

Derartige Schaltungen sind bereits bekannt. Sie haben aber den Nachteil, daß bei ihnen von außen einwirkende elektrische Felder, wie sie beispielsweise durch Polarisation von Abdecklacken beim Betrieb mit hoher Spannung und Temperatur entstehen, zur Degradation von Sperrkennlinien führen können, oder aber, daß die Durchbruchsspannung nur durch Verändern der Dicke der Passivierungsschicht in gewissen Grenzen beeinflußbar, nicht aber nach Aufbringen der Metallisierung variabel ist.

So ist aus der US-A-4 167 748 eine Darlington-Transistorschaltung bekannt, bei welcher darüber hinaus in das Substrat von der einen Hauptoberfläche her um die erste und die zweite Zone vom entgegengesetzten Leitfähigkeitstyp eine weitere, als Stoppring dienende ringförmige Zone vom gleichen Leitfähigkeitstyp wie das Grundmaterial des Substrates, aber höhere Störstellenkonzentration eindiffuniert ist und bei welcher auf die Passivierungsschicht eine als Deckelektrode dienende Metallisierung aufgebracht ist.

### Vorteile der Erfindung

Die erfindungsgemäße Darlington-Transistorschaltung mit den kennzeichnenden Merkmalen des Hauptanspruchs hat demgegenüber den Vorteil, daß die sich im Betrieb un die erste und um die zweite Zone herum ausbildende Raumladungszone innerhalb der als Stoppring dienenden ringförmigen Zone begrenzt und unterhalb der Deckelektrode von äußeren elektrischen Feldern abgeschirmt wird und daß ferner die Durchbruchsspannung an ersten und am zweiten pn-Übergang in weiten Grenzen veränderbar ist. Anspruch 2 bietet eine besonders einfache Realisierungsmöglichkeit für die Einstellung dieser Durchbruchsspannung mit Hilfe eines Spannungsteilers. Besonders vorteilhafte Weiterbildungen des Gegenstandes nach den Ansprüchen 1 und 2 ergeben sich aus den weiteren Unteransprüchen 3 bis 12.

### Zeichnung

Ausführungsbeispiele der erfindungsgemäßen Darlington-Transistorschaltung sind in der Zeichnung dargestellt und in der nachfolgenden Beschreibung näher erläutert. Es zeigen:

Figur 1 das elektrische Schaltbild einer bekannten, aus zwei npn-Transistoren bestehenden Darlington-Transistorschaltung,

Figur 2 einen Schnitt durch das Layout einer Darlington-Transistorschaltung nach Figur 1,

Figur 3 einen Teilschnitt durch eine Darlington-Transistorschaltung gemäß der Erfindung mit einem externen ohmschen Spannungsteiler zur Einstellung der Durchbruchsspannung am ersten und am zweiten pn-Übergang,

Figur 4 die Durchbruchsspannung $U_{Br}$ am ersten pn-Übergang in Abhängigkeit vom Teilerverhältnis dieses externen Spannungsteilers,

Figur 5 eine Draufsicht auf eine erfindungsgemäße Darlington-Transistorschaltung, bei der der ohmsche Spannungsteiler monolithisch integriert ist, mit geschlossenen Kontaktfenstern,

Figur 6 eine Draufsicht auf die Anordnung nach Figur 5, jedoch mit geöffneten Kontaktfenstern,

Figur 7 einen Schnitt nach der Linie A-A' der Figur 6,

Figur 8 eine Draufsicht auf einen Teil einer erfindungsgemäßen Darlington-Transistorschaltung, bei der der ohmsche Spannungsteiler teilweise durch eine Kette von Zenerdioden ersetzt ist,

Figur 9 einen Schnitt nach der Linie B-B' der Figur 8.

### Beschreibung der Ausführungsbeispiele

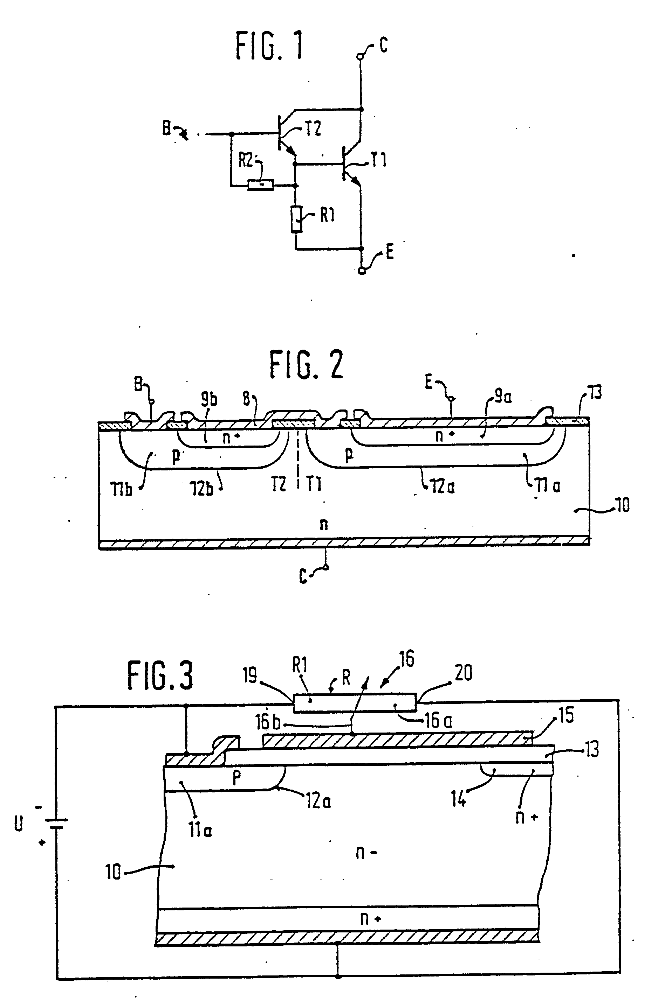

Figur 1 zeigt das elektrische Schaltbild einer Darlington-Transistorschaltung mit einem npn-Leistungstransistor $T_1$ und einem npn-Treibertransistor $T_2$ und mit je einem Widerstand $R_1$ bzw. $R_2$ parallel zu den Emitter-Basis-Strecken dieser beiden Transistoren.

In Figur 2 ist ein Schnitt durch das Layout einer Darlington-Transistorschaltung nach Figur 1 dargestellt. In das gemeinsame n-leitende Halbleitersubstrat 10 sind von einer Hauptoberfläche her die beiden p-leitenden Basiszonen 11a und 11b der beiden Transistoren $T_1$, $T_2$ eindiffundiert. Diese Zonen bilden mit dem Halbleitersubstrat 10 pn-Übergänge 12a und 12b. In die Zonen 11a und 11b hinein sind von derselben Hauptoberfläche her die entsprechenden n-leitenden Emitterzonen 9a und 9b der beiden Transistoren $T_1$ und $T_2$ eindiffundiert. Eine Passivierungsschicht 13 deckt diejenigen Teile der genannten Hauptoberfläche ab, an denen pn-Übergänge an die Oberfläche treten. Die äußeren Anschlüsse der Darlington-Transistorschaltung sind in Übereinstimmung mit Fig. 1 mit E, B und C bezeichnet, wobei E der Emitteranschluß, B der Basisanschluß und C der Kollektoranschluß ist. Zwischen der Metallisierung für den Emitteranschluß E und der Metallisierung für den Basisanschluß B befindet sich auf der genannten Hauptoberfläche eine Verbindungsmetallisierung 8 zur Verbindung der Emitterzone 9b des Treibertransitors $T_2$ mit der Basiszone 11a des Leistungstransistors $T_1$.

Die planaren pn-Übergänge 12a und 12b sollen nun durch eine Metallelektrode 15 über dem Isolator 13 so geschützt werden, daß das Sperrverhalten durch äußere Einflüsse (z.B. Stoffe mit polaren Gruppen, Alkaliionen, Metallflitter usw.) nicht in unerwünschter Weise beeinflußt werden kann.

Figur 3 zeigt ein Ausführungsbeispiel in schematischer Darstellung. Das Substrat 10 besteht dabei aus $n^-$-leitendem Silizium, der Isolator 13 aus thermisch gewachsenem Siliziumdioxid. Die Metallelektrode 15 überlappt die p-Zone 11 a und die nicht dargestellte p-Zone 11b sowie ein $n^+$-Gebiet 14, das gleichzeitig mit den Emittern der beiden Transistoren $T_1$ und $T_2$ eindiffundiert wird. Die $n^+$-leitfähige Emitterzone 9a des npn-Transistors $T_1$ ist jedoch in Figur 3 nicht dargestellt. Die erreichbare Durchbruchsspannung an den pn-Übergängen 12a und 12b hängt außer von der Grunddotierung des Siliziums wesentlich von der Dicke der Oxidschicht 13 und dem Potential der Elektrode 15 ab.

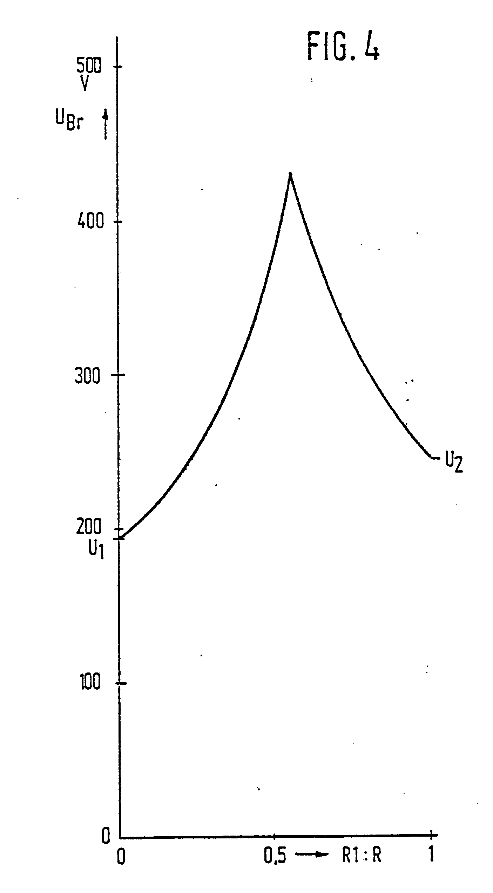

Figur 4 zeigt die Abhängigkeit der Durchbruchsspannung als Funktion des Teilerverhältnisses $R_1$: R eines externen Spannungsteilers 16. Dabei ist $U_1$ die Durchbruchsspannung an pn-Übergang 12a, die man erhält, wenn die Deckelektrode 15 ohne Zwischenschaltung des Widerstands $R_1$ direkt an die p-Zone lla angeschlossen ist. Sie ist im vorliegenden Beispiel deutlich kleiner als diejenige Durchbruchsspannung, die ohne Deckelektrode 15 erzielbar ist. Sie ist gleich der Spannung beim Verarmungsdurchbruch einer entsprechenden MOS-Struktur. $U_2$ ist die Durchbruchsspannung, die man erhält, wenn die Deckelektrode 15 unter Verzicht auf den Spannungsteiler 16 an das $n^+$-Gebiet 14 bzw. an die gemeinsame Kollektorzone der beiden npn-Transistoren $T_1$ und $T_2$ angeschlossen ist. Sie ist wegen der durch die Ladungsträgeranreicherung bedingten Feldstärkeerhöhung ebenfalls kleiner als die Durchbruchsspannung ohne Deckelektrode 15. Die größte erreichbare Durchbruchsspannung beträgt $U_1 + U_2$ bei einem Teilerverhältnis $R_1:R = U_2:(U_1+U_2)$. Der Temperaturgang der Durchbruchsspannung ist bei einem Transistor etwas kleiner als bei einer Zenerdiode mit gleicher Sperrspannung, besonders dann, wenn der Spannungsteiler 16 auf die rechte Flanke der Spannungskurve in Figur 4 eingestellt wird.

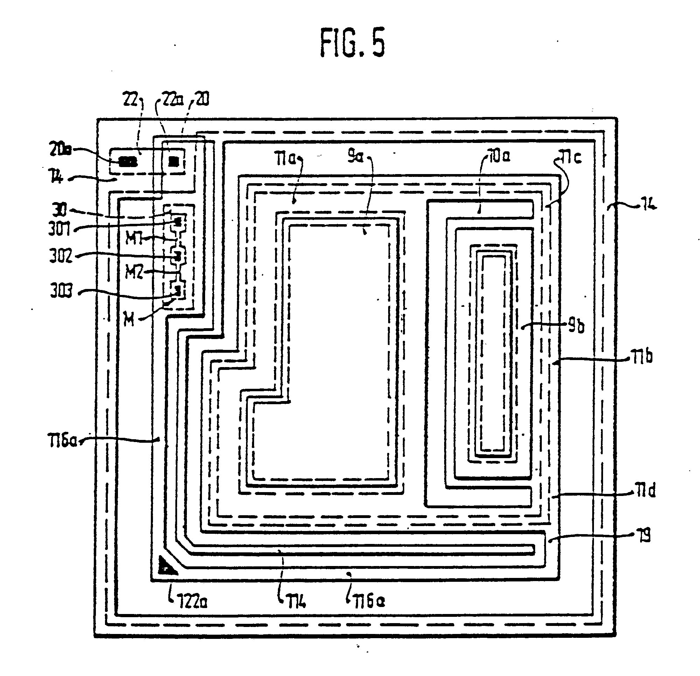

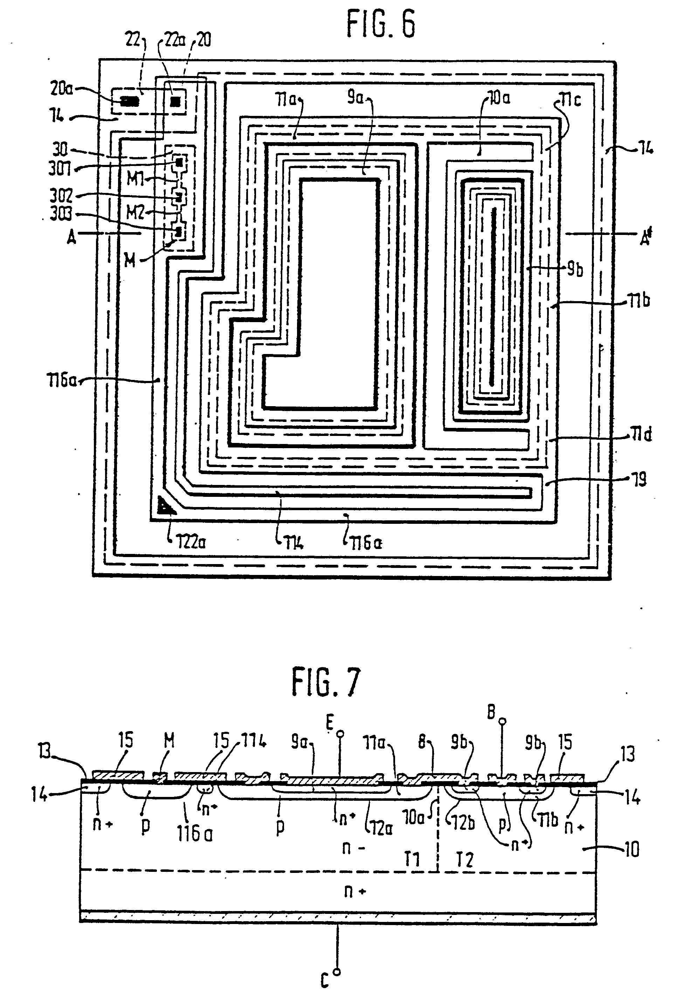

Die Figuren 5 und 7 zeigen ein Beispiel, wie der Spannungsteiler 16 monolithisch integriert werden kann. Wie in Figur 5 in der Draufsicht erkennbar, bildet dabei der Spannungsteilerwiderstand 16a eine von der Hauptoberfläche des Substrats 10 her eindiffundierte langgestreckte p-leitende Zone 116a. Diese Zone 116a besteht aus einem Ausläufer der zweiten Zone 11b und ist mindestens teilweise von der Passivierungsschicht 13 und von der darüber hinweg verlaufenden, als Deckelektrode 15 dienenden Metallisierung überdeckt. Der Rand sämtlicher Metallisierungen ist in den Figuren 5 und 6 mit gestrichelten Linienzügen gekennzeichnet. An einer bestimmten Stelle über der Zone 116a ist die Passivierungsschicht 13 unterhalb der Deckelektrode 15 entfernt. Der innerhalb des so gebildeten Kontaktfensters 122a zu liegen kommende Teil der Deckelektrode 15 bildet dabei den Abgriff 16b des Spannungsteilers 16. Das erste Ende 19 des Spannungsteilerwiderstandes 16a befindet sich in den Figuren 5 und 6 an der rechten unteren Ecke der zweiten Zone 11b und stellt einen lückenlosen Übergang der zweiten Zone 11b mit der langgestreckten Zone 116a dar. Vorstellbar und für gewisse Anwendungen sogar von Vorteil wäre auch ein direkter Anschluß der Zone 116a an die Zone 11a. Das zweite Ende 20 des Spannungsteilerwiderstandes 16a wird durch das andere Ende der Zone 116a gebildet, das sich in den Figuren 5 und 6 etwas rechts von der linken oberen Ecke des Substrats 10 befindet. Dieses zweite Ende 20 des durch die Zone 116a gebildeten Spannungsteilerwiderstandes 16a wird durch eine über die Passivierungsschicht 13 hinweggeführte Metallisierung 22 mit einem Teil des Stopprings 14 derart verbunden, daß diese Metallisierung 22 über in der Passivierungsschicht 13 angebrachte Kontaktfenster 22a mit den darunterliegenden, miteinander zu verbindenden Bereichen kontaktiert ist.

Über dem linken oberen Teil der Zone 116a ist in der Deckelektrode 15 eine Aussparung 30 angebracht, die die Passivierungsschicht 13 freilegt. In den durch die Aussparung 30 freigelegten Teil der Passivierungsschicht 13 sind Kontaktfenster 301, 302, 303 eingebracht, die sich in Längsrichtung der langgestreckten Zone 116a aneinander reihen. Diese Kontaktfenster 301, 302, 303 sind durch eine Kurzschlußmetallisierung M überbrückt, die die zwischen diesen Kontaktfenstern 301, 302, 303 liegenden Teile der dritten Zone 116a kurzschließt. Durch Auftrennen einzelner Teilstücke $M_1$, $M_2$ dieser Kurzschlußmetallisierung M ist der Spannungsteiler 16 abgleichbar, um die Durchbruchsspannungen an den pn-Übergängen 12a und 12b auf einen gewünschten Wert einstellen zu können. Ein geeignetes Verfahren zum Auftrennen solcher Metallisierungsbrücken ist in der DE-AS 22 56 688 beschrieben.

Mit der in den Figuren 5 bis 7 dargestellten Anordnung wird insgesamt erreicht, daß alle an die genannte Hauptoberfläche grenzenden Gebiete, in denen beim Anlegen einer Sperrspannung an die pn-Übergänge 12a, 12b Raumladung auftritt - im wesentlichen Gebiete der Zone 10 und ein angrenzender Streifen der Zonen 11a, 11b - durch eine über der Siliziumdioxidschicht 13 liegende metallische Deckelektrode 15 geschützt sind.

Ein C-förmiger Teil 10a der Zone 10, der die Basisgebiete 11a, llb des Leistungs- und des Treibertransistors teilweise voneinander trennt, kann ohne Nachteile für die Sperrfähigkeit von der Metallisierung 8 überdeckt werden, die an die Basiszone des Leistungstransistors $T_1$ und an die Emitterzone des Treibertransistors $T_2$ angeschlossen ist.

Zwei aus Basismaterial bestehende Stege 11c und 11d, die die Zonen 11a und 11b miteinander verbinden, stellen einen Widerstand zwischen den Basiszonen 11a und 11b der beiden Transistoren $T_1$ und $T_2$ dar, der in Figur 1 mit $R_2$ bezeichnet ist. Sollte dieser Widerstand unerwünscht sein, so kann das C-förmige Gebiet 10a zu einem ebenfalls durch eine Übermetallisierung vollständig schützbaren Ring erweitert werden.

Auf die Darstellung von Einzelheiten, die mit dem erfindungsgemäßen Gedanken nichts zu tun haben, ist zur Verbesserung der Übersichtlichkeit verzichtet worden. Dazu gehören etwa die Zahnung von Emittergebieten, ein Widerstand $R_1$ zwischen Emitter und Basis des Leistungstransistors $T_1$, eine Diode parallel zur Emitter-Kollektor-Strecke des Leistungstransistors $T_1$ und eine Überlappung der Emitter-Basis-Übergänge durch die Metallisierung.

In den Figuren 5 und 6 ist in der Umgebung des Metallstreifens 22 die Begrenzung des $n+$-Gebiets 14 so gewählt, daß überall, auch an weniger kritischen Stellen, die $n-$-Gebiete (Zone 10) vollständig durch die Metallelektrode 15 überdeckt sind.

Ein $n+$-Streifen 114, der Verbindung mit der Zone 14 hat, liegt zwischen der p-Zone 11a bzw. 11b (Basisgebiet) und der p-Zone 116a (Spannungsteilerwiderstand). Er verhindert, daß bei Anlegen von Sperrspannung an die pn-Übergänge 12a und 12b über die Raumladung eine Verbindung zwischen den Zonen 11a, 11b und der Zone 116a auftreten kann.

Zum Erreichen hoher Spannungsteilerwiderstände mit geringem Flächenbedarf ist es zu empfehlen, für die Zone 116a des Spannungsteilers einen zusätzlichen Fotoprozeß vorzusehen, um unabhängig von den Basiszonen 11a und 11b eine geringere Störstellendotierung vorzunehmen.

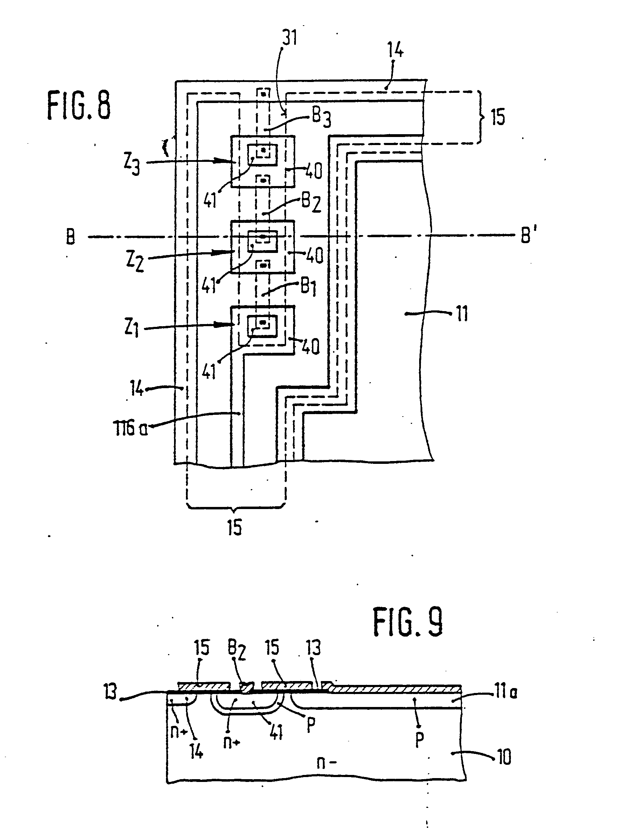

Beim Ausführungsbeispiel nach den Figuren 8 und 9 ist der in der linken oberen Ecke der Figuren 5 und 6 befindliche Teil des durch die Zone 116a gebildeten ohmschen Spannungsteilerwiderstandes 16a durch eine Kette von Zenerdioden $Z_1$, $Z_2$, $Z_3$ ersetzt. Diese Zenerdioden bestehen jeweils aus einer in die Hauptoberfläche des Substrats 10 eindiffundierten Zone 40 mit p-Leitfähigkeit und aus einer in diese Zone 40 eindiffundierten Zone 41 mit $n+$-Leitfähigkeit. Im Bereich der Zenerdioden $Z_1$, $Z_2$, $Z_3$ ist in der Metallisierung 15 eine zungenförmige Aussparung 31 vorgesehen, innerhalb die Zenerdioden $Z_1$, $Z_2$, $Z_3$ durch Metallisierungsbrücken $B_1$, $B_2$ miteinander verbunden sind. Innerhalb der Aussparung 31 ist außerdem die letzte Zenerdiode $Z_3$ der Kette $Z_1$, $Z_2$, $Z_3$ durch eine weitere Metallisierungsbrücke $B_3$ mit einem Teil des Stopprings 14 verbunden. Die Verbindungen sind dabei jeweils so ausgeführt, daß die Metallisierungsbrücken $B_1$, $B_2$, $B_3$ über in der Passivierungsschicht 13 angebrachte Kontaktfenster mit den entsprechenden, darunterliegenden Bereichen kontaktiert sind.

Bei dem in den Figuren 8 und 9 dargestellten Ausführungsbeispiel, bei dem ein Teil des ohmschen Spannungsteilerwiderstandes 16a durch eine Kette von Zenerdioden $Z_1$, $Z_2$, $Z_3$ ersetzt ist, verden die p-leitfähigen Zonen 40 dieser Zenerdioden gleichzeitig mit den p-Zonen 11a und 11b und der p-Zone 116a eindiffundiert, die $n+$-Zonen 41 gleichzeitig mit dem $n+$-Gebiet 14 und den $n+$-leitenden Emitterzonen 9a, 9b der beiden Transistoren $T_1$ und $T_2$. Die Durchbruchsspannung der Zenerdioden $Z_1$, $Z_2$, $Z_3$ liegt in der Größenordnung von 10 Volt.

Zur Einstellung der Sperrspannung der Hauptübergänge 12a und 12b können die Zenerdioden $Z_1$, $Z_2$, $Z_3$ einzeln kurzgeschlossen verden, etwa durch kurzzeitiges Anlegen einer hohen Sperrspannung, verbunden mit einem hohen Sperrstrom.

Selbstverständlich ist die Zahl der Abgleichstrecken nicht auf die der Ausführungsbeispiele festgelegt. Auch können die beschriebenen Abgleichverfahren bei Bedarf kombiniert werden.

**Patentansprüche**

1. Darlington-Transistorschaltung mit einem Leistungstransistor ($T_1$) und mit einem Treibertransistor ($T_2$), dessen Kollektor an den Kollektor des Leistungstransistors ($T_1$) und dessen Emitter an die Basis des Leistungstransistors ($T_1$) angeschlossen ist, bei der der Leistungstransistor ($T_1$) und der Treibertransistor ($T_2$) in einem gemeinsamen, die Kollektorzonen der beiden Transistoren ($T_1$, $T_2$) bildenden Substrat (10) in Planartechnik monolithisch integriert sind, bei der in das einen bestimmten Leitfähigkeitstyp aufweisende Substrat (10) von einer Hauptoberfläche her eine erste (11a) und eine zweite Zone (11b) vom entgegengesetzten Leitfähigkeitstyp, die mit dem Material des Substrats (10) einen ersten (12a) und einen zweiten pn-Übergang (12b) und die Basiszonen der beiden Transistoren ($T_1$, $T_2$) bilden, eindiffundiert sind, bei der in die beiden genannten Zonen (11a, 11b) von der genannten Hauptoberfläche des Substrats (10) her jeweils eine weitere, als Emitterzone (9a, 9b) des betreffenden Transistors dienende Zone vom gleichen Leitfähigkeitstyp wie das Grundmaterial des Substrats (10), aber höherer Störstellenkonzentration eindiffundiert ist bei der eine die genannte Hauptoberfläche des Substrats (10) mit Ausnahme von Kontaktfenstern bedeckende Passivierungsschicht (13) vorgesehen ist, bei der in das Substrat (10) von der genannten Hauptoberfläche her um die erste (11a) und die zweite Zone (11b) herum eine weitere, als Stoppring dienende ringförmige Zone (14) vom gleichen Leitfähigkeitstyp wie das Grundmaterial des Substrats (10), aber höherer Störstellenkonzentration eindiffundiert ist, und bei der auf die Passivierungsschicht (13) eine als Deckelektrode (15) dienende Metallisierung aufgebracht ist, dadurch gekennzeichnet, daß die Deckelektrode (15) sich über den Bereich zwischen den Zonen (11a, 11b) mit zum Substrat (10) entgegengesetztem Leitfähigkeitstyp und der ringförmigen Zone (14) erstreckt und sowohl die ringförmige Zone (14) als auch die der ringförmigen Zone (14) zugewandten Teile der Zonen (11a, 11b) mit zum Substrat (10) entgegengesetztem Leitfähigkeitstyp überlappt, und daß das Potential der Deckelektrode (15) so einstellbar ist, daß es einen von der gewünschten Durchbruchsspannung des ersten und zweiten pn-Übergangs (12a, 12b) abhängigen Wert annimmt, der zwischen dem Potential der ersten Zone (11a) und dem Potential eines außerhalb der ersten (11a) und der zweiten Zone (11b) liegenden Teils des Substrats (10) liegt, der einen zur ersten (11a) und zur zweiten Zone (11b) entgegengesetzten Leitfähigkeitstyp hat.

2. Darlington-Transistorschaltung nach Anspruch 1, dadurch gekennzeichnet, daß zur Einstellung des Potentials der Deckelektrode (15) ein Spannungsteiler (16) vorgesehen ist, der einen Spannungsteilerwiderstand (16a) und einen Abgriff (16b) enthält, wobei der Abgriff (16b) an die Deckelektrode (15) angeschlossen ist, das erste Ende (19) des Spannungsteilerwiderstandes (16a) mit der ersten Zone (11a) oder mit der zweiten Zone (11b) und das zweite Ende (20) des Spannungsteilerwiderstandes (16a) mit einem außerhalb der ersten (11a) und der zweiten (11b) Zone liegenden Teil des Substrats (10) verbunden ist, der einen zur ersten (11a) und zur zweiten (11b) Zone entgegengesetzten Leitfähigkeitstyp hat.

3. Darlington-Transistorschaltung nach Anspruch 2, dadurch gekennzeichnet, daß der Spannungsteiler (16) monolithisch integriert ist.

4. Darlington-Transistorschaltung nach Anspruch 3, dadurch gekennzeichnet, daß der Spannungsteilerwiderstand (16a) mindestens teilweise ein ohmscher Widerstand ist.

5. Darlington-Transistorschaltung nach Anspruch 4, dadurch gekennzeichnet, daß der Spannungsteilerwiderstand (16a) eine von der genannten Hauptoberfläche her in das Substrat (10) eindiffundierte langgestreckte Zone (116a) vom gleichen Leitfähigkeitstyp wie die erste (11a) und die zweite (11b) Zone enthält, wobei die langgestreckte Zone (116a) einen Ausläufer der ersten (11a) oder der zweiten (11b) Zone bildet und mindestens teilweise von der Passivierungsschicht (13) und von der darüber hinweg verlaufenden, als Deckelektrode (15) dienenden Metallisierung überdeckt wird, und daß an einer bestimmten Stelle über der langgestreckten Zone (116a) die Passivierungsschicht (13) unterhalb der als Deckelektrode (15) dienenden Metallisierung entfernt ist, wobei der innerhalb des so gebildeten Kontaktfensters (122a) zu liegen kommende Teil der Deckelektrode (15) den Abgriff (16b) des Spannungsteilers (16) bildet.

6. Darlington-Transistorschaltung nach Anspruch 5, dadurch gekennzeichnet, daß der Spannungsteiler (16) ein rein ohmscher Spannungsteiler ist und daß die langgestreckte Zone (116a) den gesamten Spannungsteilerwiderstand (16a) bildet.

7. Darlington-Transistorschaltung nach Anspruch 6, dadurch gekennzeichnet, daß das zweite Ende (20) des durch die langgestreckte Zone (116a) gebildeten Spannungsteilerwiderstandes (16a) durch eine über die Passivierungsschicht (13) hinweggeführte Metallisierung (22) mit einem Teil des Substrats (10), der einen zur ersten (11a) und zur zweiten (11b) Zone entgegengesetzten Leitfähigkeitstyp hat, vorzugsweise mit einem Teil des Stopprings (14), derart verbunden ist, daß diese Metallisierung (22) über in der Passivierungsschicht (13) angebrachte Kontaktfenster (22a) mit den darunterliegenden, miteinander zu verbindenden Bereichen (20, 14) kontaktiert ist.

8. Darlington-Transistorschaltung nach einem der Ansprüche 5 bis 7, dadurch gekennzeichnet, daß über einem Teil der langgestreckten Zone (116a) in der als Deckelektrode (15) dienenden Metallisierung eine Aussparung (30) angebracht ist, die die Passivierungsschicht (13) freilegt, daß in den durch die Aussparung (30) freigelegten Teil der Passivierungsschicht (13) Kontaktfenster (301, 302, 303) eingebracht sind, die sich in Längsrichtung der langgestreckten Zone (116a) aneinanderreihen, daß diese Kontaktfenster (301, 302, 303) durch eine Kurzschlußmetallisierung (M) überbrückt sind, die die zwischen den Kontaktfenstern (301, 302, 303) liegenden Teile der langgestreckten Zone (116a) kurzschließt, und daß der Spannungsteiler (16) durch Auftrennen einzelner Teilstücke (M₁, M₂) dieser Kurzschlußmetallisierung (M) abgleichbar ist, um die Durchbruchsspannung am ersten pn-Übergang (12a) auf einen gewünschten Wert einzustellen.

9. Darlington-Transistorschaltung nach Anspruch 4, dadurch gekennzeichnet, daß der Spannungsteilerwiderstand (16a) aus einem ohmschen Widerstand und aus einer Kette von zu diesem und zueinander in Reihe geschalteten Zenerdioden (Z₁, Z₂, Z₃) besteht.

10. Darlington-Transistorschaltung nach den Ansprüchen 5 und 9, dadurch gekennzeichnet, daß die Zenerdioden (Z₁, Z₂, Z₃) jeweils aus einer in die genannte Hauptoberfläche des Substrats (10) eindiffundierten Zone (40) vom gleichen Leitfähigkeitstyp wie die erste (11a) und die zweite (11b) Zone und aus einer in diese Zone (40) eindiffundierten Zone (41) vom gleichen Leitfähigkeitstyp wie das Grundmaterial des Substrats (10), aber höherer Störstellenkonzentration bestehen, daß im Bereich der Zenerdioden ($Z_1$, $Z_2$, $Z_3$) eine Aussparung (31) in der als Deckelektrode dienenden Metallisierung (15) vorgesehen ist, innerhalb der die Zenerdioden ($Z_1$, $Z_2$, $Z_3$) durch Metallisierungsbrücken ($B_1$, $B_2$) miteinander verbunden sind und innerhalb der die letzte Zenerdiode ($Z_3$) der Kette ($Z_1$, $Z_2$, $Z_3$) durch eine weitere Metallisierungsbrücke ($B_3$) mit einem Teil des Substrats (10), der einen zur ersten (11a) und zur zweiten (11b) Zone entgegengesetzten Leitfähigkeitstyp hat, vorzugsweise mit einem Teil des Stopprings (14), verbunden ist, wobei diese Metallisierungsbrücken ($B_1$, $B_2$, $B_3$) über in der Passivierungsschicht (13) angebrachte Kontaktfenster mit den entsprechenden, darunterliegenden Bereichen kontaktiert sind.

11. Darlington-Transistorschaltung nach Anspruch 10, dadurch gekennzeichnet, daß der Spannungsteiler (16) durch Kurzschließen einzelner Zenerdioden ($Z_1$, $Z_2$, $Z_3$) abgleichbar ist, um die Durchbruchsspannung am ersten pn-Übergang (12a) auf einen gewünschten Wert einzustellen.

12. Darlington-Transistorschaltung nach Anspruch 11, dadurch gekennzeichnet, daß die Zenerdioden ($Z_1$, $Z_2$, $Z_3$) durch kurzzeitiges Anlegen einer hohen Sperrspannung, verbunden mit einem hohen Sperrstrom, kurzschließbar sind.

## Claims

1 Darlington transistor circuit comprising a power transistor ($T_1$) and a driver transistor ($T_2$), the collector of which is connected to the collector of the power transistor (Tl) and the emitter of which is connected to the base of the power transistor ($T_1$), in which circuit the power transistor (Tl) and the driver transistor (T2) are monolithically integrated in planar technology into a common substrate (10) forming the collector zones of the two transistors ($T_1$, $T_2$), in which circuit the substrate (10) having a certain type of conductivity is diffused from a main surface into a first (11a) and a second zone (11b) of the opposite type of conductivity which, together with the material of the substrate (10), form a first (12a) and a second pn-type junction (12b) and the base zones of the two transistors ($T_1$, $T_2$), in which circuit a further zone, serving as the emitter zone (9a, 9b) of the transistor concerned, of the same type of conductivity as the basic material of the substrate (10) but higher in purity concentration is in each case diffused into the two said zones (11a, 11b) from the said main surface of the substrate (10), in which circuit a passivation layer (13) is provided which covers the said main surface of the substrate (10) with the exception of contact windows, in which circuit a further annular zone (14), serving as stop ring, of the same type of conductivity as the basic material of the substrate (10) but higher in purity concentration is diffused into the substrate (10) from the said main surface around the first (11a) and the second zone (11b), and in which circuit a metallisation serving as cover electrode (15) is applied to the passivation layer (13), characterised in that the cover electrode (15) extends over the area between the zones (11a, 11b) having the type of conductivity opposite to the substrate (10) and the annular zone (14) and overlaps both the annular zone (14) and the parts facing the annular zone (14) of the zones (11a, 11b) having the type of conductivity opposite to the substrate (10), and that the potential of the cover electrode (15) can be adjusted in such a manner that it assumes a value which is dependent on the desired breakdown voltage of the first and second pn-type junction (12a, 12b), which value lies between the potential of the first zone (11a) and the.potential of a part, located outside the first (11a) and the second (11b) zone, of the substrate (10) which has a type of conductivity which is opposite to the first (11a) and to the second zone (11b).

2. Darlington transistor circuit according to Claim 1, characterised in that, for adjusting the potential of the cover electrode (15), a voltage divider (16) is provided which contains a voltage divider resistor (16a) and a tap (16b), in which arrangement the tap (16b) is connected to the cover electrode (15), the first end (19) of the voltage divider resistor (16a) is connected to the first zone (11a) or to the second zone (11b) and the second end (20) of the voltage divider resistor (16a) is connected to a part, which is located outside the first (11a) and the second (11b) zone, of the substrate (10) which has a type of conductivity which is opposite to the first (11a) and to the second (11b) zone.

3. Darlington transistor circuit according to Claim 2, characterised in that the voltage divider (16) is monolithically integrated.

4. Darlington transistor circuit according to Claim 3, characterised in that the voltage divider resistor (16a) is at least partially a resistive impedance.

5. Darlington transistor circuit according to Claim 4, characterised in that the voltage divider resistor (16a) contains an elongated zone (116a), which is diffused into the substrate (10) from the said main surface, of the same type of conductivity as the first (11a) and the second (11b) zone, in which arrangement the elongated zone (116a) forms an extension of the first (11a) or the second (11b) zone and is at least partially covered by the passivation layer (13) and by the metallisation extending over the top of the passivation layer and serving as cover electrode (15), and that the passivation layer (13) is removed at a certain location above the elongated zone (116a) below the metallisation serving as cover electrode (15), in which arrangement the part, which comes to lie within the contact window (122a) formed in this manner, of the cover electrode (15) forms the tap (16b) of the voltage divider (16).

6. Darlington transistor circuit according to Claim 5, characterised in that the voltage divider (16) is a purely resistive voltage divider and that the elongated zone (116a) forms the complete voltage divider resistor (16a).

7. Darlington transistor circuit according to Claim 6, characterised in that the second end (20) of the voltage divider resistor (16a) formed by the elongated zone (116a) is connected by a metallisation (22) which is carried over the passivation layer (13), to a part of the substrate (10) which has a type of conductivity which is opposite to the first (11a) and to the second (11b) zone, preferably to a part of the stop ring (14), in such a manner that this metallisation (22) is placed into contact, via contact windows (22a) applied in the passivation layer (13), with the areas (20, 14) located underneath and to be connected to each other.

8. Darlington transistor circuit according to one of Claims 5 to 7, characterised in that a recess (30) is applied above a part of the elongated zone (116a) in the metallisation serving as cover electrode (15), which recess exposes the passivation layer (13), that contact windows (301, 302, 303) are incorporated in the part, exposed by the recess (30), of the passivation layer (13), which contact windows follow each other in the longitudinal direction of the elongated zone (116a), that these contact windows (301,302,303) are bridged by a shortcircuit metallisation (M) which short-circuits the parts of the elongated zone (116a) which lie between the contact windows (301,302,303) and that the voltage divider (16) can be calibrated by opening individual part pieces ($M_I$, $M_2$) of this short-circuit metallisation (M) to adjust the breakdown voltage at the first pn-type junction (12a) to a desired value.

9. Darlington transistor circuit according to Claim 4, characterised in that the voltage divider resistor (16a) consists of a resistive impedance and of a chain of Zener diodes ($Z_1$, $Z_2$, $Z_3$) which are connected in series with this impedance and with each other.

10. Darlington transistor circuit according to Claims 5 and 9, characterised in that the Zener diodes ($Z_1$, $Z_2$, $Z_3$) in each case consist of a zone (40), diffused into the said main surface of the substrate (10), of the same type of conductivity as the first (11a) and the second (11b) zone and of a zone (41), which is diffused into this zone (40), of the same type of conductivity as the basic material of the substrate (10) but higher in purity concentration, that in the area of the Zener diodes ($Z_1$, $Z_2$, $Z_3$) a recess (31) is provided in the metallisation (15) serving as cover electrode, within which recess the Zener diodes ($Z_1$, $Z_2$, $Z_3$) are connected to each other by metallisation bridges ($B_I$, $B_2$) and within which recess the last Zener diode ($Z_3$) of the chain ($Z_1$, $Z_2$, $Z_3$) is connected by a further metallisation bridge ($B_3$) to a part of the substrate (10) which has a type of conductivity which is opposite to the first (11a) and to the second (11b) zone, preferably to a part of the stop ring (14), in which arrangement these metallisation bridges ($B_1$, $B_2$, $B_3$) are brought into contact with the corresponding underlying areas via contact windows applied in the passivation layer (13).

11. Darlington transistor circuit according to Claim 10, characterised in that the voltage divider (16) can be calibrated by short-circuiting individual Zener diodes ($Z_1$, $Z_2$, $Z_3$) to adjust the breakdown voltage at the first pn-type junction (12a) to a desired value.

12. Darlington transistor circuit according to Claim 11, characterised in that the Zener diodes ($Z_1$, $Z_2$, $Z_3$) can be short-circuited by short-term application of a high reverse voltage in conjunction with a high reverse current.

**Revendications**

1.- Circuit Darlington à transistors avec un transistor de puissance ($T_1$) et avec un transistor d'attaque ($T_2$) dont le collecteur est raccordé au collecteur du transistor de puissance ($T_1$) et dont l'émetteur est raccordé à la base du transistor de puissance ($T_1$), circuit dans lequel le transistor de puissance ($T_1$) et le transistor d'attaque ($T_2$) sont intégrés monolithiquement selon la technique planéaire sur un substrat commun (10) constituant les zones de collecteurs des deux transistors ($T_1$, $T_2$), circuit dans lequel sur le substrat (10) ayant un type de conductibilite determiné, sont diffusées, à partir d'une surface principale, une première zone (11a) et une seconde zone (11b) de types de conductibilité opposés, ces zones constituant avec le matériau du substrat (10) une première jonction pn (12a) et une seconde jonction pn (12b), et qui constituent les zones de base des deux transistors ($T_1$, $T_2$), circuit dans lequel dans les deux zones précitées (11a, 11b) est diffusée, à partir de la surface principale précitée du substrat (10) respectivenent une autre zone, jouant le rôle de zone d'émetteur (9a, 9b) du transistor concerne, de même type de conductibilité que le matériau de base du substrat (10), mais avec une concentration de centre de capture plus élevée, circuit dans lequel il est prévu une couche de passivation (13) recouvrant la surface principale précitée du substrat (10) à l'exception de fenêtres de contact, circuit dans lequel est diffusée sur le substrat (10) à partir de la surface principale précités, autour de la première zone (11a) et de la seconde zone (11b), une autre zone annulaire (14), jouant le rôle d'anneau d'arrêt et de même type de conductivité que le matériau de base du substrat (10), mais avec une concentration plus élevée en pièges de captures, circuit dans lequel est déposée, sur la couche de passivation (13), une métallisation jouant le rôle diélectrode de recouvrement (15), circuit caractérisé en ce que l'électrode de recouvrement s'étend entre les zones (11a, 11b) avec un type de conductitivité opposé à celui du substrat (10) et la zone annulaire (14), et qu'elle déborde aussi bien sur la zone annulaire (14) que sur les parties tournées vers la zone annulaire (14) des zones (11a, 11b) de type de conductivité opposé à celui des substrats (10), et que le potentiel de l'électrode de recouvrement (15) peut être réglé de façon qu'il prenne une valeur dépendant de la tension de claquage souhaitée de la première et de la seconde jonctions pn (12a, 12b), qui se situe entre le potentiel de la première zone (11a) et le potentiel d'une partie du substrat (10) se situant en dehors de la première (11a) et de la seconde zone (11b), et qui a un type de conductibilité opposé à celui de la première zone (11a) et de la seconde zone (11b).

2.- Circuit Darlington à transistors selon la revendication 1, caractérisé en ce que pour le réglage du potentiel de l'électrode de recouvrement (15), il est prévu un diviseur de tension (16) comprenant une résistance de diviseur de tension (16a) et une prise (16b), la prise (16b) étant raccordée à l'électrode de recouvrenent (15), la première extrémité (19) de la résistance (16a) du diviseur de tension étant reliée à la première zone (11a) ou bien a la deuxième zone (11b), tandis que la deuxième extrémité (20) de la résistance (16a) du diviseur de tension est reliée à une partie du substrat (10) se situant en dehors de la première zone (11a) et de la deuxième zone (11b), cette partie du substrat ayant un type de conductibilité opposé à la première zone (11a) et à la seconde zone (11b).

3.- Circuit Darlington à transistors selon la revendication 2, caractérisé en ce que le diviseur de tension (16) est intégré monolithiquement.

4,- Circuit Darlington à transistors selon la revendication 3, caractérisé en ce que la résistance (16a) du diviseur de tension, est au moins partiellement une résistance ohmique.

5.- Circuit Darlington à transistors selon la revendication 4, caractérisé en ce que la résistance (16a) du diviseur de tension comprend une zone allongée (116a) diffusée dans le substrat (10) à partir de la surface principale précitée, et de même type de conductibilité que la première zone (11a) et que la seconde zone (11b), cette zone allongée (116a) constituant une ramification de la première. zone (11a) ou de la seconde zone (11b) et étant au moins partiellement recouverte par la couche de passivation (13) et par la métallisation siétendant au-dessus et jouant le rôle d'électrode de recouvrement (15), tandis qu'a un emplacement déterminé sur la zone allongée (116a), la couche de passivation (13) au-dessous de la métallisation jouant le rôle d'électrode de recouvrement (15), est enlevée la partie de l'électrode de recouvrement (15) venant s'appliquer à l'intérieur de la fenêtre de contact (122a) ainsi ménagée, constituant la prise (16b) du diviseur de tension (16).

6.- Circuit Darlington à transistors selon la revendication 5, caractérisé en ce que le diviseur de tension (16) est un diviseur de tension purement ohmique et que la zone allongée (116a) constitue la totalité de la résistance (16a) du diviseur de tension.

7.- Circuit Darlington à transistors selon la revendication 6, caractérisé en ce que la seconde extrémité (20) de la résistance (16a), constituée par la zone allongée (116a), du diviseur de tension, est reliée, de préférence avec une partie de l'anneau d'arrêt (14), a une partie du substrat (10) qui a un type de conductibilité opposé à la première zone (11a) et à la seconde zone (11b), cette métallisation (22) étant en contact par l'intermédiaire de la fenêtre de contact ménagée dans la couche de passivation (13), aux zones placées en-dessous et devant être reliées ensemble (20, 14).

8.- Circuit Darlington à transistors selon une des revendications 5 à 7, caractérisé en ce que, audessus d'une partie de la zone allongée (116a), dans la métallisation jouant le rôle d'électrode de recouvrement (15), est ménagé un évidement (30) qui libère la couche de passivation (13), tandis que dans la partie de la couche de passivation (13) libérée par l'évidement (30) des fenêtres de contact (301, 302, 303) qui s'alignent l'une sur liautre en direction longitudinale de la zone allongée (116a), ces fenêtres de contact (301, 302, 303) étant pontées par une métallisation de court-circuit (M), qui court-circuite les parties de la zone allongée (116a) entre les fenêtres de contact (301, 302, 303), tandis que le diviseur de tension (16) est susceptible d'être réglé par découpage de parties individuelles ($M_1$, $M_2$) de cette métallisation de court-circuit (M), pour régler à une valeur souhaitée la tension de claquage sur la première jonction pn (12a).

9.- Circuit Darlington à transistors selon la revendication 4, caractérisé en ce que la résistance (16a) du diviseur de tension est constituée par une résistance ohmique et par une chaîne de diodes de Zener ($Z_1$, $Z_2$, $Z_3$) branchées à cette résistance ohmique et branchées série les unes par rapport aux autres.

10.- Circuit Darlington à transistors selon les revendications 5 et 9, caractérisé en ce que les diodes de Zener ($Z_1$, $Z_2$, $Z_3$) sont respectivement constituées d'une zone (40), du même type de conductibilité que la première zone (11a) et que la seconde zone (11b), diffusées dans la surface principale précitée du substrat (10), et d'une zone (41), de même type de conductibilité que le matériau de base du substrat (10) mais comportant une concentration de centre de capture plus élevée, diffusée dans cette zone (40), tandis qu'il est prévu dans la zone des diodes de Zener ($Z_1$, $Z_2$, $Z_3$) un évidement (31) dans la métallisation (15) jouant le rôle d'électrode de recouvrement, évidement à l'inférieur duquel les diodes de Zener ($Z_1$, $Z_2$, $Z_3$) sont reliées entre elles par des ponts de métallisation ($B_1$, $B_2$), et à l'intérieur duquel la dernière diode de Zener ($Z_3$) de la chaîne ($Z_1$, $Z_2$, $Z_3$) est reliée, de préférence par une partie de l'anneau d'arrêt (14), par un autre pont de métallisation ($B_3$) à une partie du substrat (10) qui a un type de conductibilité opposé à la première zone (11a) et a la seconde zone (11b), ces ponts de métallisation (B$_1$, B$_2$, B$_3$) étant en contact, par l'intermédiaire de fenêtres de contact ménagées dans la couche de passivation (13), avec les zones correspondantes placées en-dessous.

11.- Circuit Darlington à transistors selon la revendication 10, caractérisé en ce que le diviseur de tension (16) est susceptible d'être réglé par courtcircuit de diodes individuelles (Z$_1$, Z$_2$, Z$_3$) pour régler la tension de claquage sur la première jonction pn (12a) à une valeur souhaitée.

12.- Circuit Darlington à transistors selon la revendication 11, caractérisé en ce que les diodes de Zener (Z$_1$, Z$_2$, Z$_3$) sont susceptibles d'être court-circuitées par une application de courte durée d'une tension de blocage élevée combinée avec un courant de blocage élevé.

0 099 897

FIG. 1

FIG. 2

FIG. 3

1

0 099 897

FIG. 4

# FIG. 5

# FIG. 6

# FIG. 7

**FIG. 8**

**FIG. 9**